# EUROPEAN PATENT SPECIFICATION

(11) **EP 3 062 117 B1**
(45) Date of publication and mention of the grant of the patent: **28.03.2018**
(21) Application number: 16164874.6
(22) Date of filing: 14.06.2013
(51) Int. Cl.: G01R 31/28, G01R 31/319, G01R 1/04

(54) **METHOD OF CONTACTING INTEGRATED CIRCUIT COMPONENTS IN A TEST SYSTEM**
VERFAHREN ZUR KONTAKTIERUNG VON INTEGRIERTEN SCHALTKOMPONENTEN IN EINEM PRÜFSYSTEM
PROCÉDÉ DE MISE EN CONTACT DES COMPOSANTS D'UN CIRCUIT INTÉGRÉ DANS UN SYSTÈME DE TEST

(43) Date of publication of application: 31.08.2016
(62) Divisional of application: 13172041.9
(73) Proprietor: Rasco GmbH, 83059 Kolbermoor (DE)
(72) Inventor: Croce, Karl, 83334 Inzell (DE)
(74) Representative: Grünecker Patent- und Rechtsanwälte PartG mbB

(56) References cited:
- JP-A- 2009 111 246
- KR-A- 20090 038 726
- US-A- 4 757 255
- US-A- 4 954 774
- US-B1- 6 194 907
- US-B1- 6 259 264

## Description

### Field of the Invention

The present invention relates to a method of contacting integrated circuit components in a test system and to a corresponding test system.

### Prior Art

For testing the quality of integrated circuits components (ICs) the ICs are brought into contact with a contactor body of an automatic test system to verify their function. Based on the test results, the ICs may be sorted to make them available for packaging or other applications. To do so, contactor bodies having contacting elements with contacting tips for contacting the corresponding contact areas of an IC during the test. Test signals are send via the contactor tips to the IC and response signals are received in return. Examples can be found in the documents US 6 194 907 B1, KR 2009 0038726 A, US 4 757 255 A, JP 2009 111246 A, US 4 954 774 A, US 6 259 264 B1, US 4 845 426 A, and US 2004/0222809 A disclosing different alternative configurations of probers. Additionally, the document US 2013/0133339 A discloses a hot/cold test equipment for a NAND Flash memory, wherein Nitrogen is used for the cold test and a thermoelectric element is used for the hot test. The contact areas / leads of ICs often comprise copper (Cu) having a coating with a material such as nickel (Ni), palladium (Pd), gold (Au) or tin (Sn). When contacting the contact areas / leads of ICs the contacting tips of the test system for testing the ICs for proper function, with respect to the at high and/or low temperatures, for example, swarf is generated due to the relative motion between the contacting tips of contactor springs and the leads of the IC under test. The contactor tips partially abrade the coating of the leads. This swarf accumulates on the contacting tips and oxidizes. The oxidized debris has a low electrical conductance, resulting in an increase of the contact resistance. Such an effect is particularly observed when testing ICs with leads having a pure tin coating.

This effect is disadvantageous and causes problems because it may lead to wrong test results and/or causes dead time of the testing apparatus, for cleaning purposes or for replacing the contactor bodies with the contacting tips.

### Description of the Invention

The problem underlying the present invention in view of the prior art is to provide a method of contacting integrated circuit components in a test system overcoming the disadvantages of contacting the ICs according to the prior art.

The above-mentioned problem is solved by the method of contacting integrated circuit components according to claim 1.

The method of contacting integrated circuit components according to the invention comprises the steps of heating an inert gas to a temperature of at least 42°C; providing an atmosphere comprising the heated inert gas; and contacting contact regions of contact springs of a contact socket with respective contacting areas of an integrated circuit component to be tested, the contacting being performed in the provided atmosphere comprising the heated inert gas; wherein a flow of the heated inert gas is directed and concentrated to the contact regions of the contact springs of the contact socket by means of nozzles provided in the contact socket. This method according to the invention has the advantage that the atmosphere comprising the inert gas reduces or avoids the oxidization of the abrasion debris on the contacting tips of the contact socket. Accordingly, the contact resistance remains at a lower level when compared to the same procedure under air atmosphere.

The inventive method can be developed such that the inert gas comprises at least one gas selected from the group including nitrogen, carbon dioxide and the noble gases, in particular from the group including nitrogen, helium, neon and argon, and wherein the inert gas preferably comprises nitrogen. Each of these gases reduces the oxidization of abrasion debris, in particular tin from tin-coated leads of ICs. In particular using nitrogen is preferred, since this gas can be used for cooling the ICs when performing low temperature tests (below 20°C, down to -30°C), for mid-range temperatures tests (20°C to 42°C) and also for high temperature tests (42°C or more, up to 175°C).

According to another development, the atmosphere comprising an inert gas is provided continuously. This has the advantage that the complete contacting procedure can be performed under the atmosphere with the inert gas, such that the fraction of air, in particular oxygen, in the provided atmosphere can be kept at a low level.

The inert gas may, on the other hand, be provided repeatedly but only when necessary to improve the conductivity at the tips of the contacting elements. Hence, tests may be normally performed under air atmosphere interrupted with cycles of providing an inert gas atmosphere until the contact resistance is reduced below a given threshold. The inert gas has a temperature of at least 42°C, in particular a temperature in the range of 42°C to 175°C, preferably in the range of 50°C to 175°C, most preferably in the range of 100°C to 175°C. Accordingly, the inert gas atmosphere is provided at temperature for conducting high temperature tests of ICs.

According to another development, the inert gas has a temperature of less than 42°C, in particular in the range of -30°C to 20°C or 20°C to 42°C. The inert gas may thus be used to cool the ICs under test to perform mid temperature and/or low temperature tests.

According to another development, the method comprises the further step of heating or cooling the inert gas. Hence, the inert gas can be provided at a desired temperature by heating or cooling it, depending on the initial temperature of the inert gas before heating or cooling.

The above-mentioned problem is further solved by a contact socket for testing integrated circuit components according to independent claim 6. The contact socket for testing integrated circuit components according to the invention comprises contact regions of contact springs for contacting respective contacting areas of an integrated circuit component; means for heating an inert gas to a temperature of at least 42°C; and means for providing an atmosphere comprising the heated inert gas; wherein the contact socket is configured to perform contacting of an integrated circuit component in the provided atmosphere under operating conditions; and wherein the contact socket includes at least one nozzle for directing and concentrating a flow of the heated inert gas to the contact regions of the contact springs of the contact socket. The contact socket may further comprise an inert gas chamber defining a space for the atmosphere comprising an inert gas. This has the advantage that the atmosphere comprising the inert gas is confined to a small volume and therefore reduces the total amount of inert gas required.

The contact socket may be further developed such that the inert gas chamber comprises a gas inlet for introducing the inert gas into the chamber and a gas outlet for discharging the inert gas.

The invention further provides a contactor for contacting an integrated circuit component, comprising the contact socket according to the invention or one of its developments, and a contact holder for holding an integrated circuit.

The contactor comprises means for heating the inert gas and / or means for cooling the inert gas.

According to another development of the contactor, the gas outlet and the gas inlet may be interconnected outside of the chamber to provide a recirculation circuit for the inert gas. The recirculation circuit further reduces the required amount of inert gas.

The invention also provides a test system for testing integrated circuit components, comprising a contactor or a plurality of contactors according to the invention or one of its developments, in particular, and may further comprise a handler for feeding integrated circuit components to the contactor or the plurality of contactors.

According to another development, the integrated circuit components may be provided as parts of a test strip including a plurality of separate integrated circuit components or the integrated circuit components may be provided as parts of a waver probe including a plurality of integrated circuit components.

The advantages of the test system and its developments correspond to the advantages given above for the method according to the inventions and its developments.

Further features and advantages of the present invention will be described in the following with reference to the figures, which illustrate only examples of embodiments of the present invention. The illustrated and described features may be suitably combined with each other.

### Brief Description of the Drawings

- Fig. 1: illustrates a test system according to the prior art.
- Fig. 2: illustrates an embodiment of the contact socket according to the invention.
- Fig. 3A;B;C;D: illustrate another embodiment of the invention.
- Fig. 4: illustrate a further embodiment of the invention.
- Fig. 5: illustrates a test result when performing the method according to the invention

### Description of the Embodiments

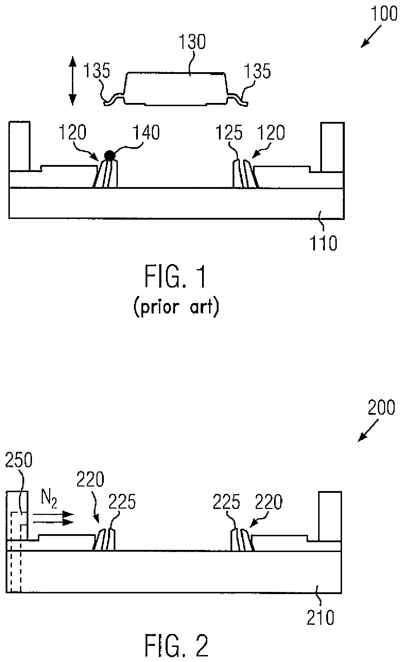

Figure 1 shows a test system / contactor according to the prior art.

The test system 100 has a contact socket 110 having contact elements 120 with contacting tips 125 for contacting respective contact areas (e.g. leads) 135 of an integrated circuit 130 during a test. The IC 130 is placed in the test system 100 and moved towards the contact socket 110 (arrow down) until the tips 125 of the contacting elements (e.g. springs) are in contact with the leads 135 of the IC 130. After the test has been performed the IC 130 is lifted (arrow up), can be removed and be replaced with the next IC to be tested. Due to the slight relative movement between the tips 125 and the leads 135, portions of tin are scraped of the leads 135 and may cover the tips 125. This tin chemically reacts with the oxygen in the surrounding air and oxidizes forming a layer of debris 140 on the tips 125. This oxidized tin has a high electrical resistance, which may lead to a malfunctioning of the test system 100. The contact resistance can be easily measured by applying a particular voltage while measuring the current through the contact elements 120. Internal tests performed by the applicant have revealed that nitrogen may preferably be used for temperature tests of ICs below 42°C, in particular also for the range of 20°C to 42°C as the conditioning of nitrogen can be better controlled than that of air.

Figure 2 shows an embodiment of a contact socket according to the invention.

The test system 200 according to the invention comprises similar components as the test system according to Fig. 1. The corresponding reference numbers for similar components are increased by 100. The test system 200 further comprises means 250 for providing an atmosphere comprising an inert gas, and in this embodiment the inert gas is N₂. The means 250 may be formed of a line 250 for conducting the nitrogen to a nozzle at the end of the line 250. The test system 200 is configured such that the contact tips 225 of the contact socket 210 of the test system 200 are contacting respective contacting areas 235 of an integrated circuit component 230 to be tested, and the test system 200 is configured to perform the contacting in the provided nitrogen atmosphere under operating conditions. The nitrogen atmosphere suppresses the oxidization of the debris which occasionally falls off the tips 225, for example during the next contacting cycle. A contactor comprising the contact socket 210 of this embodiment may further comprise heating means that may heat the nitrogen gas to perform a high temperature function test of the IC 230.

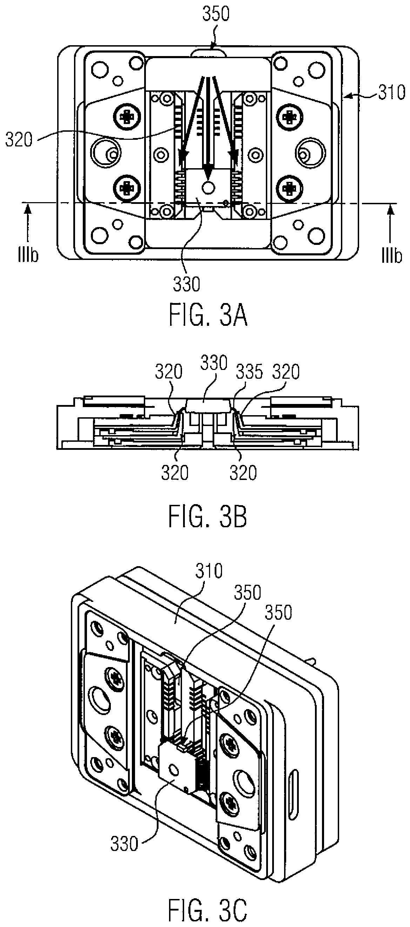

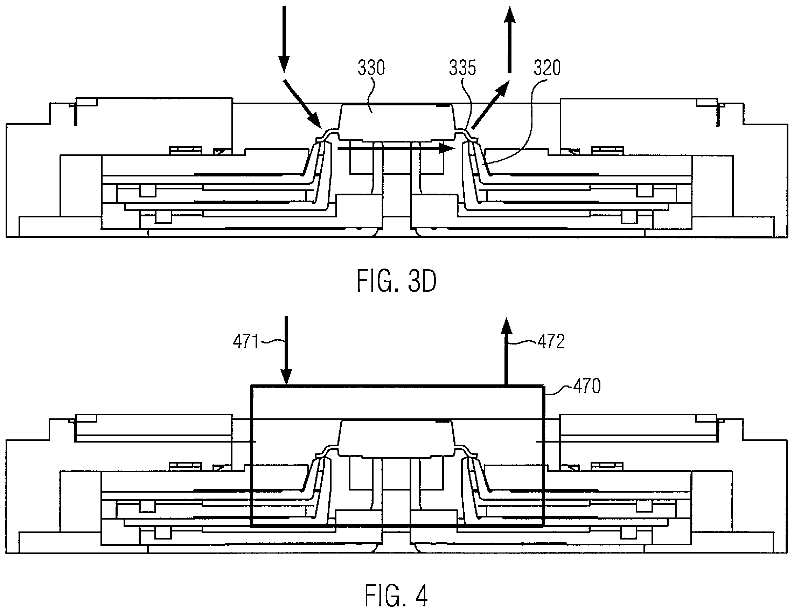

Figure 3 A; B; C; D illustrate another embodiment of the invention.

The contact socket 310 according to this embodiment of the invention comprises similar components as the contact socket 210 according to Fig. 2. The corresponding reference numbers for similar components are increased by 100. Figure 3A is a plan view on the contact socket 310. Fig. 3B is a cross sectional view along line C-C in Fig. 3A. Fig 3C is perspective view of the contact socket 310 and Fig. 3D illustrates the flow of inert gas around the contact sites. In all views an IC 330 is located in the contact socket with IC leads 335 contacting respective contact springs 320 of the contact socket 310. Nozzles 350 are provided in the contact socket 310 for directing the flow of inert gas (e.g. nitrogen) to the contacting sites.

Figure 4 illustrate a further embodiment of the invention.

In Figure 4, additionally to the embodiment of Figure 3, an inert gas chamber 470 is provided. Moreover, a gas inlet 471 and a gas outlet 472 are provided. Accordingly, a limited volume has to be filled with inert gas and further, optionally a circular flow of inert gas can be implemented, further reducing the consumption of inert gas.

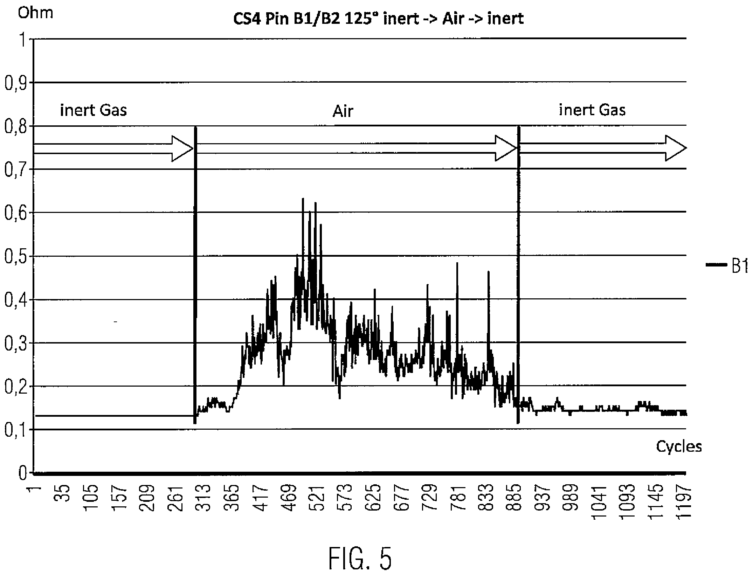

Figure 5 shows test results when performing the method according to the invention when compared with the method according to the prior art.

Figure 5 shows a test performed at a representative contacting site CS4 of a contactor in a test system. The vertical axis represents the resistance in Ohm and the horizontal axis represents the number of contacted ICs. Inert gas (Nitrogen) or air is supplied at a temperature of 125°C. When air is supplied, the contact resistance increases and then shows statistical changes, however, always at a level that significantly causes problems for performing the desired test. In contrast, when nitrogen is supplied and the contacting of the tips of the contactor and the leads of the ICs is performed in a nitrogen atmosphere, the contact resistance remains at a low level that does not influence the test. First a nitrogen atmosphere is provided until the 280^{th} contacting, second an air atmosphere is provided from the 281^{st} until the 920^{th} contacting, and finally again a nitrogen atmosphere is provided from the 921^{st} contacting onward. It is evident that even when oxidized debris increasing the contact resistance has already been present, there is a recovery to a low contact resistance when the nitrogen gas is supplied.

## Claims

1. A method of contacting integrated circuit components, comprising the steps of:
heating an inert gas to a temperature of at least 42°C;
providing an atmosphere comprising the heated inert gas; and contacting contact regions (225) of contact springs (320) of a contact socket (210, 310) with respective contacting areas (335) of an integrated circuit component (330) to be tested, the contacting being performed in the provided atmosphere comprising the heated inert gas; wherein a flow of the heated inert gas is directed and concentrated to the contact regions (225) of the contact springs (320) of the contact socket (210, 310) by means of nozzles (250, 350) provided in the contact socket (210, 310).

2. The method of claim 1, wherein the inert gas comprises at least one gas selected from the group including nitrogen and the noble gases, in particular from the group including nitrogen, helium, neon and argon, and wherein the inert gas preferably comprises nitrogen.

3. The method of claim 1 or 2, wherein the atmosphere comprising the heated inert gas is provided continuously.

4. The method of one of claims 1 to 3, wherein the inert gas has a temperature in the range of 42°C to 175°C, preferably in the range of 50°C to 175°C.

5. The method of one of claims 1 to 4, further comprising the step of heating the inert gas and/or further comprising the step of cooling the inert gas.

6. A contactor for contacting an integrated circuit component, comprising a contact socket (210, 310) for contacting an integrated circuit component (330) and a contact holder for holding an integrated circuit, wherein the contactor further comprises means for heating an inert gas to a temperature of at least 42°C, and the contact socket (210,310) comprises:
contact regions (225) of contact springs (320) for contacting respective contacting areas (335) of an integrated circuit component (330); and means (250) for providing an atmosphere comprising the heated inert gas; wherein the contact socket (210, 310) is configured to perform contacting of an integrated circuit component (330) in the provided atmosphere under operating conditions; and wherein the contact socket (210, 310) includes at least one nozzle (250, 350) for directing and concentrating a flow of the heated inert gas to the contact regions (225) of the contact springs (320) of the contact socket (210, 310).

7. The contactor of claim 6, further comprising:
an inert gas chamber (470) defining a space for the atmosphere comprising the heated inert gas.

8. The contactor of one of claims 6 to 7, wherein the inert gas chamber (470) comprises a gas inlet (471) for introducing the inert gas into the chamber (470) and a gas outlet (472) for discharging the inert gas.

9. The contactor of one of claims 6 to 8, further comprising:
means for cooling the inert gas.

10. The contactor of one of claims 6 to 9, wherein the gas outlet (472) and the gas inlet (471) are interconnected outside of the chamber (470) to provide a recirculation circuit for the inert gas.

11. A test system (200) for testing integrated circuit components, comprising:
a contactor or a plurality of contactors according to any one of claims 6 to 10, in particular, further comprising a handler for feeding integrated circuit components (330) to the contactor or the plurality of contactors.

12. The test system of claim 11, wherein the integrated circuit components (330) are provided as parts of a test strip including a plurality of separate integrated circuit components or wherein the integrated circuit components (330) are provided as parts of a waver probe including a plurality of integrated circuit components.

## Patentansprüche

1. Verfahren zum Kontaktieren von integrierten Schaltkomponenten, das die Schritte umfasst:
Erwärmen eines Inertgases auf eine Temperatur von wenigstens 42°C;
Bereitstellen einer Atmosphäre, die das erwärmte Inertgas umfasst; und
Kontaktieren von Kontaktbereichen (225) von Kontaktfedern (320) eines Kontaktsockels (210, 310) mit entsprechenden Kontaktflächen (335) einer zu prüfenden integrierten Schaltkomponente (330), wobei das Kontaktieren in der bereitgestellten Atmosphäre, die das erwärmte Inertgas umfasst, durchgeführt wird;
wobei eine Strömung des erwärmten Inertgases auf die Kontaktbereiche (225) der Kontaktfedern (320) des Kontaktsockels (210, 310) mithilfe von in dem Kontaktsockel (210, 310) bereitgestellten Düsen (250, 350) gerichtet und konzentriert wird.

2. Verfahren nach Anspruch 1, wobei das Inertgas wenigstens ein Gas umfasst, das aus der Gruppe ausgewählt wird, die Stickstoff und die Edelgase aufweist, insbesondere aus der Gruppe, die Stickstoff, Helium, Neon und Argon aufweist, und wobei das Inertgas vorzugsweise Stickstoff umfasst.

3. Verfahren nach Anspruch 1 oder 2, wobei die Atmosphäre, die das erwärmte Inertgas umfasst, kontinuierlich bereitgestellt wird.

4. Verfahren nach einem der Ansprüche 1 bis 3, wobei das Inertgas eine Temperatur im Bereich von 42°C bis 175°C, vorzugsweise im Bereich von 50°C bis 175°C aufweist.

5. Verfahren nach einem der Ansprüche 1 bis 4, das des Weiteren den Schritt zum Erwärmen des Inertgases umfasst und/oder ferner den Schritt zum Kühlen des Inertgases umfasst.

6. Kontaktvorrichtung zum Kontaktieren einer integrierten Schaltkomponente, die einen Kontaktsockel (210, 310) zum Kontaktieren einer integrierten Schaltkomponente (330) und einen Kontakthalter zum Halten einer integrierten Schaltung umfasst, wobei die Kontaktvorrichtung des Weiteren eine Einrichtung zum Erwärmen eines Inertgases auf eine Temperatur von wenigstens 42°C umfasst und der Kontaktsockel (210, 310) umfasst:
Kontaktbereiche (225) von Kontaktfedern (320) zum Kontaktieren jeweiliger Kontaktflächen (335) einer integrierten Schaltkomponente (330);
und eine Einrichtung (250) zum Bereitstellen einer Atmosphäre, die das erwärmte Inertgas umfasst;
wobei der Kontaktsockel (210, 310) konfiguriert ist, um das Kontaktieren einer integrierten Schaltkomponente (330) in der bereitgestellten Atmosphäre unter Betriebsbedingungen durchzuführen;
und wobei der Kontaktsockel (210, 310) wenigstens eine Düse (250, 350) aufweist, um eine Strömung des erwärmten Inertgases auf die Kontaktbereiche (225) der Kontaktfedern (320) des Kontaktsockels (210, 310) zu richten und zu konzentrieren.

7. Kontaktvorrichtung nach Anspruch 6, die des Weiteren umfasst:
eine Inertgaskammer (470), die einen Raum für die Atmosphäre definiert, die das erwärmte Inertgas umfasst.

8. Kontaktvorrichtung nach einem der Ansprüche 6 bis 7, wobei die Inertgaskammer (470) einen Gaseinlass (471) zum Einleiten des Inertgases in die Kammer (470) und einen Gasauslass (472) zum Auslassen des Inertgases umfasst.

9. Kontaktvorrichtung nach einem der Ansprüche 6 bis 8, die des Weiteren umfasst:
eine Einrichtung zum Kühlen des Inertgases.

10. Kontaktvorrichtung nach einem der Ansprüche 6 bis 9, wobei der Gasauslass (472) und der Gaseinlass (471) außerhalb der Kammer (470) miteinander verbunden sind, um einen Rezirkulationskreislauf für das Inertgas bereitzustellen.

11. Prüfsystem (200) zum Prüfen von integrierten Schaltkomponenten, das umfasst:
eine Kontaktvorrichtung oder eine Vielzahl von Kontaktvorrichtungen nach einem der Ansprüche 6 bis 10, die des Weiteren insbesondere eine Steuerungsvorrichtung zum Zuführen von integrierten Schaltkomponenten (330) in die Kontaktvorrichtung oder die Vielzahl von Kontaktvorrichtungen umfasst.

12. Prüfsystem nach Anspruch 11, wobei die integrierten Schaltkomponenten (330) als Teile eines Prüfstreifens mit einer Vielzahl von separaten integrierten Schaltkomponenten bereitgestellt werden oder wobei die integrierten Schaltkomponenten (330) als Teile einer Schwebesonde mit einer Vielzahl von integrierten Schaltkomponenten bereitgestellt werden.

## Revendications

1. Procédé de mise en contact de composants de circuits intégrés, comprenant les étapes de :
chauffage d'un gaz inerte à une température d'au moins 42° C ;
fourniture d'une atmosphère comprenant le gaz inerte chauffé ; et
mise en contact de régions de contact (225) de ressorts de contact (320) d'un connecteur femelle de contact (210, 310) avec des zones mise en contact respectives (335) d'un composant de circuit intégré (330) à tester, la mise en contact s'effectuant dans l'atmosphère fournie comprenant le gaz inerte chauffé ;
dans lequel
un flux du gaz inerte chauffé est dirigé et concentré sur les régions de contact (225) des ressorts de contact (320) du connecteur femelle de contact (210, 310) au moyen de buses (250, 350) fournies dans le connecteur femelle de contact (210, 310).

2. Le procédé de la revendication 1, dans lequel le gaz inerte comprend au moins un gaz sélectionné dans le groupe incluant l'azote et les gaz nobles, en particulier dans le groupe incluant l'azote, l'hélium, le néon et l'argon, et dans lequel le gaz inerte comprend de préférence l'azote.

3. Le procédé de la revendication 1 ou 2, dans lequel l'atmosphère comprenant le gaz inerte chauffé est fournie en continu.

4. Le procédé de l'une des revendications 1 à 3, dans lequel le gaz inerte présente une température dans une plage allant de 42° C à 175° C, de préférence de 50° C à 175° C.

5. Le procédé de l'une des revendications 1 à 4, comprenant en outre l'étape de chauffage du gaz inerte et/ou comprenant en outre l'étape de refroidissement du gaz inerte.

6. Contacteur pour la mise en contact d'un composant de circuit intégré, comprenant un connecteur femelle de contact (210, 310) pour mettre en contact un composant de circuit intégré (330) et un support de contact destiné à supporter un circuit intégré, dans lequel le contacteur comprend en outre un moyen de chauffer un gaz inerte jusqu'à une température d'au moins 42° C, et le connecteur femelle de contact (210, 310) comprend :
des régions de contact (225) de ressorts de contact (320) pour mettre en contact des zones de mise en contact respectives (335) d'un composant de circuit intégré (330) ;
et un moyen (250) de fournir une atmosphère comprenant le gaz inerte chauffé ;
dans lequel le connecteur femelle de contact (210, 310) est configuré pour procéder à la mise en contact d'un composant de circuit intégré (330) dans l'atmosphère fournie dans des conditions d'exploitation ;
et
dans lequel le connecteur femelle de contact (210, 310) comprend au moins une buse (250, 350) pour diriger et concentrer un flux du gaz inerte chauffé sur les régions de contact (225) des ressorts de contact (320) du connecteur femelle de contact (210, 310).

7. Le contacteur de la revendication 6, comprenant en outre :
une chambre de gaz inerte (470) définissant un espace pour l'atmosphère comprenant le gaz inerte chauffé.

8. Le contacteur d'une des revendications 6 à 7, dans lequel la chambre de gaz inerte (470) comprend une entrée de gaz (471) pour l'introduction du gaz inerte dans la chambre (470) et une sortie de gaz (472) pour le déchargement du gaz inerte.

9. Le contacteur de l'une des revendications 6 à 8, comprenant en outre :
un moyen de refroidir le gaz inerte.

10. Le contacteur de l'une des revendications 6 à 9, dans lequel la sortie de gaz (472) et l'entrée de gaz (471) sont interconnectées à l'extérieur de la chambre (470) pour fournir un circuit de recyclage pour le gaz inerte.

11. Système de test (200) pour tester des composants de circuit intégré, comprenant :
un contacteur ou une pluralité de contacteurs selon l'une quelconque des revendications 6 à 10, en particulier comprenant en outre un dispositif de gestion pour fournir des composants de circuit intégré (330) au contacteur ou à la pluralité de contacteurs.

12. Le système de test de la revendication 11, dans lequel les composants de circuit imprimé (330) sont fournis en tant que pièces sur une bande de test comprenant une pluralité de composants de circuit imprimé séparés ou dans lequel les composants de circuit imprimé (330) sont fournis en tant que pièces d'une tranche sous sonde comprenant une pluralité de composants de circuit imprimé.
